# EUROPÄISCHE PATENTSCHRIFT

(11) **EP 1 260 075 B1**
(45) Veröffentlichungstag und Bekanntmachung des Hinweises auf die Patenterteilung: **27.05.2009**
(21) Anmeldenummer: 01996958.3
(22) Anmeldetag: 10.11.2001
(51) Int. Cl.: H04L 27/34, H04L 1/00, H03M 13/35, H04L 25/49

(54) **VERFAHREN ZUR CODIERTEN MODULATION UNTER BERÜCKSICHTIGUNG DER FEHLEREMPFINDLICHKEIT DER NUTZDATEN UND VERWÜRFELUNG DIESER DATEN NACH DER CODIERUNG**
METHOD FOR CODED MODULATION TAKING ACCOUNT OF THE ERROR SENSITIVITY OF THE USER DATA AND ENCRYPTING SAID DATA AFTER CODING
PROCEDE DE MODULATION CODEE PRENANT EN COMPTE LA SENSIBILITE AUX ERREURS DES DONNEES UTILES ET EMBROUILLAGE DE CES DONNEES APRES CODAGE

(30) Priorität: 17.11.2000 DE 10057282
(43) Veröffentlichungstag der Anmeldung: 27.11.2002
(73) Patentinhaber: ROBERT BOSCH GMBH, 70442 Stuttgart (DE)
(72) Erfinder: HOFMANN, Frank, 31139 Hildesheim (DE)
(86) Internationale Anmeldenummer: PCT/DE2001/004222
(87) Internationale Veröffentlichungsnummer: WO 2002/041594

(56) Entgegenhaltungen:
- EP-A- 0 490 552
- EP-A- 0 540 232
- US-A- 5 812 601
- US-A- 6 031 874
- IMAI H ET AL: "A NEW MULTILEVEL CODING METHOD USING ERROR-CORRECTING CODES" IEEE TRANSACTIONS ON INFORMATION THEORY, IEEE INC. NEW YORK, US, Bd. IT-23, Nr. 3, 1977, Seiten 371-377, XP000760819 ISSN: 0018-9448
- YAKHNO T M ET AL: "USING THE ECL I PS E INTERVAL DOMAIN LIBRARY IN CAD" THE ICL SYSTEMS JOURNAL, INTERNATIONAL COMPUTERS LIMITED, GB, Bd. 12, Nr. 2, November 1997 (1997-11), Seiten 330-348, XP000833455 ISSN: 1364-310X

## Beschreibung

### Stand der Technik

Die Erfindung geht aus von einem Verfahren zur codierten Modulation nach der Gattung des unabhängigen Patentanspruchs.

Es ist bereits bekannt, eine codierte Modulation einzusetzen, bei der Kanalcodierung und Modulation gemeinsam optimiert werden. Äquivalent zu dem Begriff codierte Modulation ist auch die Bezeichnung Multilevel-Codierung bekannt. Vor der codierten Modulation erfolgt eine Quellencodierung zur Datenreduktion.

Aus US 6,031,874 ist es bereits bekannt, eine codierte Modulation zu verwenden und dabei einen ungleichen Fehlerschutz anzuwenden. Dafür wird ein so genannter Produktcode, der aus einem äußeren und einem inneren Code besteht, verwendet. Aus EP 490552 A2 ist es bekannt, bei einem HDTV-Signal einen ungleichen Fehlerschutz zu verwenden, wobei die Daten nach ihrer Bedeutung unterschiedlich kanalcodiert werden, sodass parallele Datenströme entstehen. Zusätzlich kann auch hier ein Produktcode aus einem inneren und äußeren Code verwendet werden, der auf den jeweiligen parallelen Signalstrom angewendet wird. Aus US 5,812,601 ist es bereits bekannt, eine codierte Modulation zu verwenden, wobei pro parallelem Datenstrom nur eine Coderate verwendet wird und auch nur ein Verwürfler pro parallelem Datenstrom.

### Vorteile der Erfindung

Das erfindungsgemäße Verfahren zur codierten Modulation mit den Merkmalen des unabhängigen Patentanspruchs hat demgegenüber den Vorteil, dass ein ungleichmäßiger Fehlerschutz bei einer codierten Modulation eingesetzt wird, wobei hier für Nutzbits mit unterschiedlicher Fehlerempfindlichkeit unterschiedliche Coderaten eingesetzt werden. Die Coderate und die Anzahl der zu codierenden Nutzbits können dabei unabhängig voneinander gewählt werden.

Das erfindungsgemäße Verfahren ermöglicht insgesamt eine einfachere Implementierung.

Durch die in den abhängigen Ansprüchen aufgeführten Maßnahmen und Weiterbildungen sind vorteilhafte Verbesserungen des im unabhängigen Patentanspruch angegebenen Verfahrens zur codierten Modulation möglich.

Besonders vorteilhaft ist, dass die mit den unterschiedlichen Coderaten jeweils kanalcodierten Nutzbits zur zeitlichen Verwürfelung auf parallele Verwürfler verteilt werden, um danach mit einem Multiplexer wieder zu einem Signalstrom zusammengefasst zu werden. Damit werden vorteilhafterweise nur die Nutzbits, die mit der gleichen Coderate kanalcodiert wurden, auch miteinander verwürfelt. Damit wird die Kanaldecodierung und die der Kanaldecodierung vorangehenden Entwürfelung im Empfänger entsprechend einfach.

Alternativ ist es von Vorteil, dass pro Stufe nach dem Codierer ein Verwürfler eingesetzt wird, der die mit den unterschiedlichen Coderaten kanalcodierten Nutzbits nacheinander getrennt zeitlich verwürfelt. Somit wird ein Verwürfler eingesetzt, der die notwendige Intelligenz besitzt, um die mit den unterschiedlichen Coderaten kanalcodierten Nutzbits in entsprechende Gruppen einzuteilen und dann jeweils zeitlich miteinander zu verwürfeln.

Weiterhin ist es von Vorteil, dass dem Empfänger die mindestens zwei unterschiedlich verwendeten Coderaten zur Kanalcodierung und die jeweilige Anzahl der mit den unterschiedlichen Coderaten kanalcodierten Nutzbits einem Empfänger signalisiert werden. Damit ist dem Empfänger klar, mit welchen Coderaten die unterschiedlich fehlerempfindlichen Nutzbits kanalcodiert wurden und wie die Anzahl der unterschiedlich codierten Nutzbits ist, um eine entsprechende Entwürfelung und Kanalcodierung richtig durchzuführen.

Weiterhin ist es von Vorteil, dass sowohl ein Sender und als auch ein Empfänger Mittel zur Durchführung des erfindungsgemäßen Verfahrens aufweisen.

### Zeichnung

Ausführungsbeispiele der Erfindung sind in der Zeichnung dargestellt und werden in der nachfolgenden Beschreibung näher erläutert. Es zeigt Figur 1 eine Partitionierung einer 4-ASK, Figur 2 ein Blockschaltbild des erfindungsgemäßen Sender, Figur 3 ein Blockschaltbild des erfindungsgemäßen Empfängers und Figur 4 ein Flußdiagramm des erfindungsgemäßen Verfahrens.

### Beschreibung

Das digitale Übertragungssystem Digital Radio Mondiale (DRM) für die Übertragungsbänder unterhalb 30 MHz wird zur Zeit entwickelt. Es wurde entschieden, dass als die Kanalcodierung eine Multilevel-Codierung (MLC) verwendet wird. Dabei werden die Kanalcodierung und die Modulation gemeinsam optimiert, weshalb man auch von codierter Modulation spricht. Kanalcodierung fügt den Daten Redundanz hinzu, anhand derer Übertragungsfehler erkannt und gegebenenfalls korrigiert werden können.

Bei einem höherstufigen Modulationsverfahren mit einer q-nären Signalkonstellation hat das Signalalphabet genau q Werte. Die Grundlage für die MLC bildet die Partitionierung des Signalalphabets in Teilmengen. Jedem Teilungsschritt wird eine Komponente des Adreßvektors der Signalraumdarstellung zugewiesen. Hierbei wird jede Komponente mit einem eigenen Code geschützt. Betrachtet man eine 2^{m}-stufige Signalkonstellation, ergibt sich eine Aufteilung in n Stufen, wenn m=n ist, entsprechend dem Adreßvektor c (=c₀, c₁, ..., cₙ₋₁). Die Stufigkeit m der Modulation ist beispielsweise nicht notwendigerweise gleich der Anzahl der Stufen, wenn eine 64-QAM (Quadraturamplitudenmodulation) eingesetzt wird.

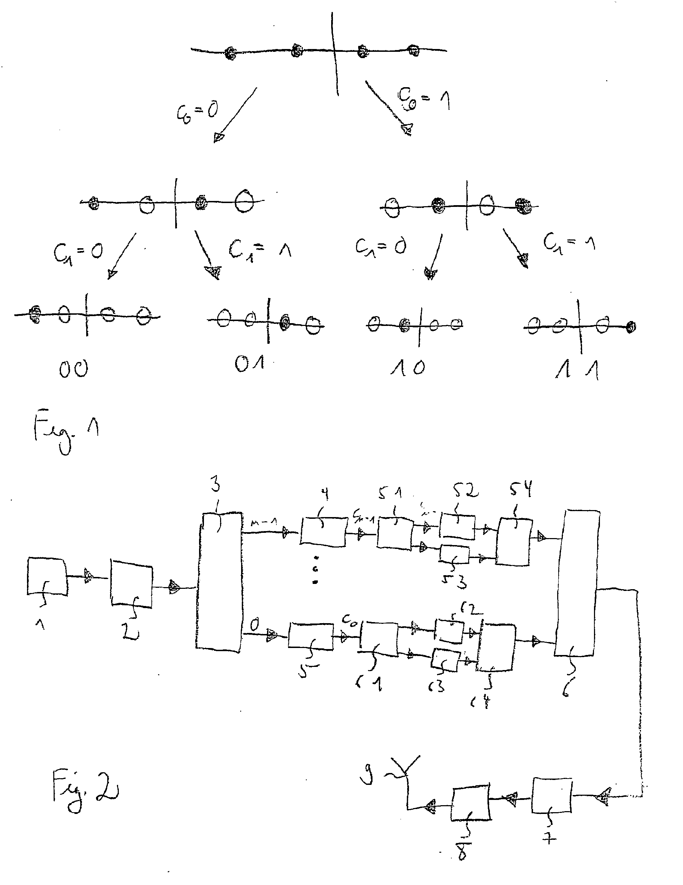

Figur 1 zeigt die Partitionierung einer 4-ASK (Amplitude Shift Keying = Amplitudenumtastung). Bei der 4-ASK werden also vier Zustände codiert. Die Codierung des Datenstroms erfolgt mit n parallelen Codierern, wobei der Code C₀ die kleinste Coderate R₀ aufweist, d.h. die meiste Redundanz zufügt und die fehleranfälligste Position des Adreßvektors schützt. In Figur 1 auf dem obersten Zustandsstrahl sind vier Zustände durch gefüllte Kreise markiert. Über die mittleren beiden Zustandsstrahle gelangt man dann zu den einzelnen codierbaren Zuständen bei einer 4-ASK. Der ersten Stufe wird entweder c₀ = 0 oder 1. Entsprechend werden die vier.ausgefüllten Kreise auf zwei Zahlenstrahle verteilt, die zueinander komplementär ausgefüllte und leere Kreise aufweisen. Bei den unteren vier Zustandsstrahlen werden nun die einzelnen Zustände bei einer 4-ASK nämlich 00, 01, 10 und 11 codiert. Dabei weist der Zustand 00 ganz links einen ausgefüllten Kreis, der dann von drei leeren Kreisen gefolgt wird, auf. Der Zustand 01 weist ausgehend von links an der dritten Stelle den ausgefüllten Kreis auf. Der Zustand 10 weist ausgehend von links an der zweiten Stelle den ausgefüllten Kreis auf und der Zustand 11 weist ganz rechts den ausgefüllten Kreis auf. Die übrigen Positionen werden durch leere Kreise für eine 0 symbolisiert.

In Figur 2 ist ein Blockschaltbild des erfindungsgemäßen Senders dargestellt. Im Datenspeicher 1 sind Daten enthalten, die mit dem erfindungsgemäßen Sender zu versenden sind. Es sind hier jedoch auch andere Datenquellen nutzbar. Diese Daten werden von dem Datenspeicher 1 an einen Quellencodierer 2 übertragen, der eine Quellencodierung vornimmt, um die zu übertragenden Daten in der Menge zu reduzieren. Die so quellencodierten Daten mit den Nutzbits werden dann an einen Bitmultiplexer 3 übertragen, der den Datenstrom auf n parallele Leitungen verteilt. An jeder dieser n Leitungen, die mit 0 bis n-1 durchnumeriert werden, ist ein jeweiliger Codierer angeschlossen, der einen der Datenströme (q₀...qₙ₋₁) kanalcodiert. Beispielhaft ist hier ein Codierer 5 in der Leitung 0 und ein Codierer 4 in der Leitung n-1 dargestellt. Am Ausgang der jeweiligen Codierer liegen die Signale c₀ bzw. cₙ₋₁ vor. Die Codierer 4 und 5 führen die Kanalcodierung mittels einer Faltungscodierung durch und fügen damit den Nutzbits wieder Redundanz zu. Die Codierer 4 und 5 werden hier zwei unterschiedliche Coderaten einsetzen. Der Quellencodierer 2 hat die Nutzbits identifiziert, die einen ersten Fehlerschutz benötigen und die restlichen Nutzbits, die einen zweiten Fehlerschutz benötigen. Dazu verwenden dann die Kanalcodierer 4 und 5 jeweils eine unterschiedliche Coderate. Die Nutzbits werden dabei also nach vorgegebenen Regeln auf die Stufen verteilt, ohne dass eine Auswertung der Nutzbits diesbezüglich erfolgt. Zunächst werden dann die Nutzbits auf die Stufen und die Codierer 4 und 5 verteilt, die mit der ersten Coderate kanalcodiert werden und dann folgen die Nutzbits, die mit der zweiten Coderate kanalcodiert werden. Dazu wird dann die Coderate bei allen vorhandenen Codierern umgeschaltet.

Da nun am Ausgang der Codierer 4 und 5 unterschiedlich kanalcodierte Nutzbits vorliegen, werden diese im nachgeschalteten Verwürfler getrennt zeitlich verwürfelt. Ein auf den Codierer 5 folgender Multiplexer 61 und ebenso ein auf den Codierer 4 folgender Multiplexer 51 verteilen die unterschiedlich codierten Nutzbits jeweils auf Verwürfler 62 und 63 sowie 52 und 53. Die Verwürfler werden im Englischen als Interleaver bezeichnet. Verwürfeln bedeutet, dass zeitlich nah beieinanderliegende Bits, die Informationen mit hoher Korrelation mit benachbarten Bits aufweisen, zeitlich voneinander getrennt werden, um bei einem Burstfehler mit der Kanaldecodierung noch hinreichend viele Fehler empfängerseitig korrigieren zu können, so dass die Anzahl der hörbaren Fehler minimiert wird. Die verwürfelten Nutzbits werden dann ausgehend von den Verwürflern 52 und 53 im Demultiplexer 54 wieder zu einem Signalstrom zusammengefügt. Die verwürfelten Nutzbits der Verwürfler 62 und 63 werden analog im Demultiplexer 64 wieder zu einem Signalstrom zusammengefügt.

Die so kanalcodierten Daten werden dann im Block 6 Signalraumpunkten zugeordnet, um dann die jeweiligen Modulationssymbole zu erzeugen.

Als die Komponentencodes in den einzelnen Codierern 4 und 5 werden Faltungscodes mit Punktierung verwendet. Bei der MLC werden hier für jede Stufe wenigstens zwei unterschiedliche Coderaten verwendet. Nach der Modulation im Funktionsblock 6 werden dem Signalstrom Signalisierungsdaten hinzugefügt, die einem Empfänger signalisieren, welche unterschiedlichen Coderaten zur Kanalcodierung verwendet wurden und wieviele Bits pro Rahmen mit der ersten Coderate und wieviel Bits mit der zweiten Coderate kanalcodiert wurden. Damit ist es dann einem Empfänger möglich, eine korrekte Demodulation und Entwürfelung sowie Kanaldecodierung durchzuführen.

In Figur 2 werden dann die so codierten Modulationssymbole von dem Funktionsblock 6 an einen OFDM (Orthogonal Frequency Division Multiplex = Orthogonaler Frequenzmultiplex)-Modulator 7 übertragen, der die einzelnen Modulationssymbole auf nahe beieinanderliegende Frequenzträger, die zueinander orthogonal sind, verteilt. Die so entstandenen OFDM-Signale werden dann in einem analogen Hochfrequenzteil 8 gemischt, verstärkt und dann mit einer Antenne 9 ausgestrahlt.

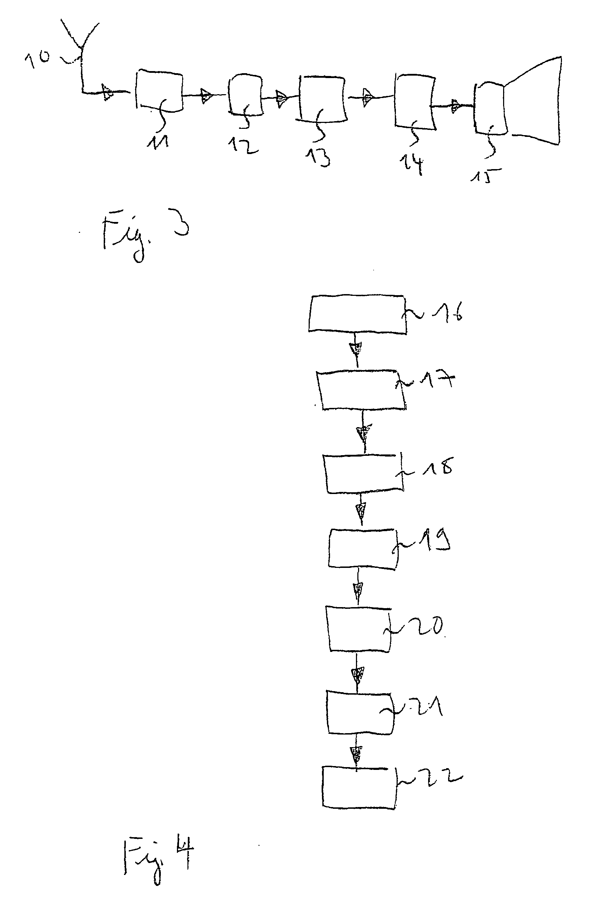

In Figur 3 ist ein Blockschaltbild des erfindungsgemäßen Empfängers dargestellt. Eine Antenne 10 zum Empfang der OFDM-Signale ist an einen Eingang eines Hochfrequenzempfangsteils 11 angeschlossen. Das Hochfrequenzempfangsteil 11 setzt die empfangenen Signale in eine Zwischenfrequenz um, verstärkt und filtert sie. Darüber hinaus überträgt das Hochfrequenzempfangsteil 11 diese Signale an ein Digitalteil 12, der die empfangenen Signale digitalisiert und eine OFDM-Demodulation durchführt. Die so gewonnenen Modulationssymbole werden dann im Prozessor 13 demoduliert, einer Entwürfelung, einer Kanaldecodierung und einer Quellendecodierung unterzogen, um sie dann in analoge Signale umzuwandeln. Die analogen Signale werden dann von einem Audioverstärker 14 verstärkt, um sie schließlich mit dem Lautsprecher 15 wiederzugeben. Dabei werden insbesondere die Signalisierungsdaten ausgewertet, die die verwendeten beiden Coderaten und die Anzahl der Nutzbits pro Rahmen für eine Coderate angeben, verwendet. Damit ist es dann einem Empfänger möglich, eine korrekte Entwürfelung und Kanaldecodierung durchzuführen.

Anstatt von zwei Coderaten ist es auch möglich, mehrere Coderaten einzusetzen. Anstatt des Quellencodierers 2 kann auch der Bitmultiplexer 3 entscheiden, welche Bits mit welcher Coderate kanalcodiert werden. Dies kann im Weiteren auch einem übergeordneten Prozessor, der im erfindungsgemäßen Sender angeordnet ist, als Aufgabe zugeordnet werden. Alternativ ist es hier möglich, auch Multimediadaten zu empfangen, die dann optisch wiedergegeben werden.

In Fig. 4 wird das erfindungsgemäße Verfahren zur codierten Modulation als Flußdiagramm dargestellt. In Verfahrensschritt 16 werden die Daten vom Datenspeicher 1 bereitgestellt und durch den Quellencodierer 2 einer Quellencodierung unterzogen. Im Weiteren bestimmt hier der Quellencodierer 2, welche Nutzbits mit welcher Coderate kanalcodiert werden. Es wird also ein ungleichmäßiger Fehlerschutz festgelegt. In Verfahrensschritt 17 wird der so entstandene Datenstrom in parallel verlaufende Datenströme durch den Bitmultiplexer 3 aufgeteilt. Alternativ ist es hier möglich, dass der Bitmultiplexer 3 die Aufteilung der Nutzbits für die unterschiedliche Kanalcodierung durchgeführt wird. In Verfahrensschritt 18 führen die einzelnen Codierer 4 und 5 die Kanalcodierung durch. Dabei werden die Nutzbits mit zwei unterschiedlichen Coderaten kanalcodiert, wie es durch den Quellencodierer 2 festgelegt wurde. In Verfahrensschritt 19 werden die so unterschiedlich kanalcodierten Nutzbits zeitlich verwürfelt. Dabei werden nur die Nutzbits miteinander zeitlich verwürfelt, die auch mit der gleichen Coderate kanalcodiert wurden. Dies kann entweder durch parallel geschaltete Verwürfler erfolgen oder durch einen intelligenten Verwürfler, der sequentiell die mit den unterschiedlichen Coderaten kanalcodierten Nutzbits getrennt voneinander verwürfelt. In Verfahrensschritt 20 werden im Funktionsblock 6 den so entstandenen kanalcodierten Nutzbits Signalraumpunkte zugeordnet, um die Modulationssymbole zu erzeugen. In Verfahrensschritt 21 werden die Modulationssymbole einer OFDM-Modulation unterzogen und in Verfahrensschritt 22 erfolgt die Verstärkung bzw. Versendung der OFDM-Signale. Zusätzlich werden hierbei noch die beiden unterschiedlichen Coderaten für die Nutzbits und die Anzahl pro Übertragungsrahmen der Nutzbits pro verwendeter Coderate von dem Sender als Signalisierung an die Empfänger übertragen, so dass die Empfänger in der Lage sind, die unterschiedlich kanalcodierten Nutzbits zu entwürfeln und zu kanaldecodieren.

## Patentansprüche

1. Verfahren zur codierten Modulation von digitalen Daten, wobei die digitalen Daten Nutzbits aufweisen, wobei die codierte Modulation mehrstufig ausgeführt wird, wobei die Nutzbits nach ihrer Fehlerempfindlichkeit eingeteilt werden, wobei die Nutzbits in parallele Signalströme aufgeteilt werden, wobei jeder Signalstrom von einem Codierer (4, 5) einer Kanalcodierung mit wenigstens zwei unterschiedlichen Coderaten unterzogen wird, **dadurch gekennzeichnet, dass** die unterschiedlichen Coderaten in Abhängigkeit von der Fehlerempfindlichkeit der Nutzbits eingesetzt werden, sodass ein erster Teil der Nutzbits mit einer ersten Coderate und wenigstens ein zweiter Teil der Nutzbits mit wenigstens einer weiteren Coderate kanalcodiert werden, wobei zunächst der erste Teil der Nutzbits von den jeweiligen Codierern (4, 5) zur Kanalcodierung mit der erste Coderate und dann der zweite Teil der Nutzbits mit der weiteren Coderate kanalcodiert wird, wobei dabei die Coderate bei allen vorhandenen Codierern umgeschaltet wird, dass die mit unterschiedlichen Coderaten kanalcodierten Nutzbits jedes Signalstroms getrennt zeitlich verwürfelt werden und dass die kanalcodierten und verwürfelten Nutzbits dann Signalraumpunkten zugeordnet werden, um Modulationssymbole zu erzeugen.

2. Verfahren nach Anspruch 1, **dadurch gekennzeichnet, dass** pro Signalstrom die mit unterschiedlichen Coderaten kanalcodierten Nutzbits zur zeitlichen Verwürfelung auf parallele Verwürfler (52, 53, 62, 63) verteilt werden und danach wieder mit einem Demultiplexer (54, 64) zu einem Signalstrom zusammengefasst werden.

3. Verfahren nach Anspruch 1, **dadurch gekennzeichnet, dass** pro Signalstrom nach dem Codierer (4, 5) ein Verwürfler die mit unterschiedlichen Coderaten kanalcodierten Nutzbits nacheinander getrennt zeitlich verwürfelt.

4. Verfahren nach einem der vorhergehenden Ansprüche, **dadurch gekennzeichnet, dass** die mindestens zwei unterschiedlichen Coderaten und eine jeweilige Anzahl der mit den unterschiedlichen Coderaten kanalcodierten Nutzbits einem Empfänger signalisiert werden.

5. Verwendung eines Senders zur Durchführung des Verfahrens nach einem der Ansprüche 1 bis 4.

## Claims

1. Method for coded modulation of digital data, the digital data having user bits, the coded modulation being carried out in a number of stages, the user bits being subdivided according to their error sensitivity, the user bits being split into parallel signal streams, each signal stream being subjected, by a coder (4, 5), to channel coding at at least two different code rates, **characterized in that** the different code rates are used on the basis of the error sensitivity of the user bits, with the result that a first part of the user bits is channel-coded at a first code rate and at least one second part of the user bits is channel-coded at at least one further code rate, the first part of the user bits being channel-coded first of all at the first code rate by the respective channel-coding coders (4, 5) and the second part of the user bits then being channel-coded at the further code rate, the code rate being changed over in all existing coders, **in that** the user bits in each signal stream which have been channel-coded at different code rates are scrambled separately in time, and **in that** the channel-coded and scrambled user bits are then assigned to signal space points in order to generate modulation symbols.

2. Method according to Claim 1, **characterized in that,** for each signal stream, the user bits which have been channel-coded at different code rates are distributed among parallel scramblers (52, 53, 62, 63) for temporal scrambling and are then combined again to form a signal stream using a demultiplexer (54, 64).

3. Method according to Claim 1, **characterized in that,** for each signal stream after the coder (4, 5), a scrambler scrambles the user bits, which have been channel-coded at different code rates, in succession and separately in time.

4. Method according to one of the preceding claims, **characterized in that** the at least two different code rates and a respective number of the user bits, which have been channel-coded at the different code rates, are signalled to a receiver.

5. Use of a transmitter for carrying out the method according to one of Claims 1 to 4.

## Revendications

1. Procédé de modulation codée de données numériques, les données numériques présentant des bits utiles, la modulation codée étant réalisée sur plusieurs niveaux, les bits utiles étant répartis en fonction de leur sensibilité aux erreurs, les bits utiles étant distribués dans des flux de signaux parallèles, chaque flux de signal étant soumis par un codeur (4, 5) à un codage en canal avec au moins deux facteurs de code différents, **caractérisé en ce que** les différents facteurs de code sont utilisés en fonction de la sensibilité aux erreurs des bits utiles de sorte qu'une première partie des bits utiles fait l'objet d'un codage en canal avec un premier facteur de code et au moins une deuxième partie des bits utiles fait l'objet d'un codage en canal avec au moins un facteur de code supplémentaire, le codage en canal étant réalisé par le codeur (4, 5) correspondant tout d'abord à la première partie des bits utiles avec le premier facteur de code et ensuite à la deuxième partie des bits utiles avec l'autre facteur de code, le facteur de code étant ici permuté sur tous les codeurs présents, **en ce que** les bits utiles de chaque flux de signal codés en canal avec des facteurs de code différents sont brouillés séparément dans le temps et **en ce que** les bits utiles codés en canal et brouillés sont ensuite associés à des points d'espace de signal afin de générer des symboles de modulation.

2. Procédé selon la revendication 1, **caractérisé en ce que** pour chaque flux de signal, les bits utiles codés en canal avec des facteurs de code différents sont répartis sur des brouilleurs (52, 53, 62, 63) en parallèle en vue de leur brouillage dans le temps et sont ensuite de nouveau regroupés en un flux de signal avec un démultiplexeur (54, 64).

3. Procédé selon la revendication 1, **caractérisé en ce que** pour chaque flux de signal, un brouilleur après le codeur (4, 5) effectue le brouillage dans le temps des bits utiles codés en canal séparément les uns après les autres avec des facteurs de code différents.

4. Procédé selon l'une des revendications précédentes, **caractérisé en ce que** les au moins deux facteurs de code différents et un nombre respectif de bits codés en canal avec les facteurs de code différents sont signalés à un récepteur.

5. Utilisation d'un émetteur pour mettre en oeuvre le procédé selon l'une des revendications 1 à 4.
